# DEMANDE DE BREVET EUROPEEN

(11) **EP 1 978 544 A1**
(43) Date de publication de la demande: **08.10.2008**
(21) Numéro de dépôt: 08102801.1
(22) Date de dépôt: 20.03.2008
(51) Int. Cl.: H01L 21/02, H01L 23/522

(54) **Realisation de condesateurs MIM à 3 dimensions dans le dernier niveau de metal d'un circuit intégré**

(30) Priorité: 02.04.2007 FR 0754216
(71) Demandeur: STMICROELECTRONICS SA, 92120 Montrouge (FR)
(72) Inventeur: Cremer, Sébastian, 38360, SASSENAGE (FR); Giraudin, Jean-Christophe, 38190, BERNIN (FR); Serret, Emmanuelle, 38410, VAULNAVEYS LE HAUT (FR)
(74) Mandataire: Ilgart, Jean-Christophe

(57) **Abrégé**

L'invention concerne le domaine de la microélectronique et en particulier celui des condensateurs MIM (« MIM » pour Métal-Isolant-Métal) à 2 ou 3 dimensions dans les circuits intégrés. Elle prévoit la réalisation d'un circuit intégré formé à partir d'un substrat et comprenant plusieurs niveaux métalliques d'interconnexion dans lequel, dans un même plan parallèle au plan principal du substrat figure une pluralité de lignes métalliques d'interconnexion horizontales épaisses, ainsi qu'un ou plusieurs condensateurs MIM doté d'armatures métalliques orthogonales au plan principal du substrat.

## Description

### DOMAINE TECHNIQUE

L'invention concerne le domaine de la microélectronique et en particulier celui des condensateurs MIM (« MIM » pour Métal-Isolant-Métal) à 2 ou 3 dimensions dans les circuits intégrés.

Elle prévoit la réalisation d'un circuit intégré formé à partir d'un substrat et comprenant plusieurs niveaux métalliques d'interconnexion dans lequel, dans un même plan parallèle au plan principal du substrat figure une pluralité de lignes métalliques horizontales épaisses, ainsi qu'un ou plusieurs condensateurs MIM dotés d'armatures métalliques comportant des portions orthogonales au plan principal du substrat et des portions parallèles au plan principal du substrat.

L'invention trouve des applications notamment dans le domaine des circuits intégrés dotés d'au moins un module RF ou/et analogique.

L'invention apporte des améliorations en termes de capacité ou/et de densité d'intégration des condensateurs MIM au sein d'un circuit intégré et s'adapte à des technologies de circuits intégrés dans lesquels l'épaisseur de diélectrique entre les lignes métalliques horizontales d'interconnexion est très faible.

L'invention permet également d'améliorer la défectivité au sein d'un circuit intégré doté de condensateurs MIM.

### ETAT DE LA TECHNIQUE ANTÉRIEURE

Il existe différentes méthodes pour incorporer des condensateurs dans un circuit électronique intégré.

Certaines méthodes aboutissent à la réalisation d'un condensateur doté d'armatures métalliques parallèles au plan principal du substrat et dont l'armature supérieure est située par exemple dans le dernier niveau d'interconnexions métalliques. Un tel condensateur, pour avoir une capacité importante, occupe une portion de surface projetée sur le substrat également importante. L'encombrement qui en résulte rend plus difficile la disposition de pistes métalliques et de vias au sein des couches d'interconnexions.

Des condensateurs à armatures dites « verticales » dont les armatures sont orthogonales au plan principal du substrat ont aussi été réalisés. Ces condensateurs sont généralement formés à l'aide d'un procédé de type Damascène, par remplissage de tranchées à l'aide d'un empilement MIM comprenant une fine couche métallique, une fine couche isolante et une autre fine couche métallique. Ces condensateurs ont généralement une capacité limitée.

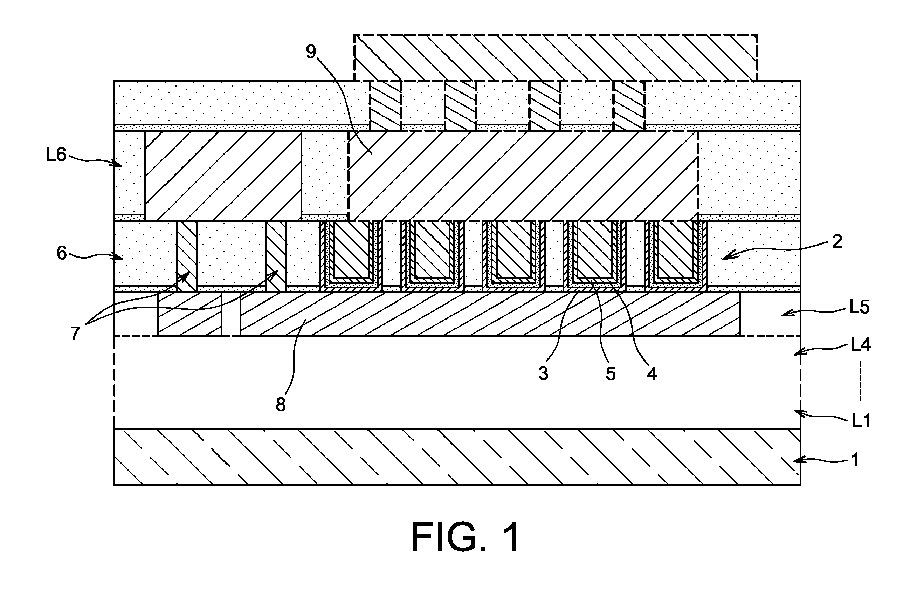

Sur la figure 1, un dispositif microélectronique doté d'au moins un condensateur MIM (« MIM » pour Métal-Isolant-Métal) à 3 dimensions dit « MIM 3D » est illustré. Ce dispositif est doté d'au moins un condensateur à 3 dimensions prévu pour répondre à la fois à des exigences d'encombrement réduit et de capacité importante. Ce condensateur comporte des portions d'armatures orthogonales au plan principal du substrat et des portions d'armatures parallèles au plan principal du substrat.

Le dispositif est formé à partir d'un substrat 1 sur lequel une pluralité de composants et de niveaux métalliques d'interconnexions superposés, par exemple de 6 niveaux métalliques d'interconnexions L1, L2, L3, L4, L5, L6 (les composants et les 4 premiers niveaux métalliques d'interconnexion L1, ..., L4, étant schématisés sur la figure 1 par un bloc en traits discontinus au-dessus du substrat 1) ont été réalisés. Ce condensateur 2 est doté d'une première armature comportant une partie « verticale » formée dans un plan orthogonal au plan principal du substrat 1, à partir d'une première fine couche métallique 3, d'une deuxième armature comportant une partie « verticale » formée dans un plan orthogonal au plan principal du substrat 1, à partir d'une deuxième fine couche métallique 5 séparée de la première fine couche métallique 3 par une fine couche de matériau diélectrique 4, la première fine couche métallique 3, la fine couche diélectrique 4 et la deuxième fine couche métallique 5 recouvrant les parois et le fond de tranchées réalisées dans une couche isolante 6 dans laquelle des vias métalliques 7 de connexion entre le cinquième niveau L5 métallique et le sixième niveau L6 métallique sont réalisés. Les armatures du condensateur comportent également des parties d'armatures horizontales formées au fond desdites tranchées à partir des couches métalliques 3 et 5 entre des couches métalliques 8 et 9 respectivement du 5ème niveau et du 6ème niveau.

La couche métallique 8 sur laquelle l'empilement MIM repose au fond des tranchées, est généralement réalisée à base de cuivre.

Lors de la réalisation de cette couche métallique 8, le cuivre induit des contraintes qui ont tendance à se traduire, après dépôt du cuivre, par la formation de protubérances (« hillocks » selon une terminologie anglo-saxonne) en surface de cette partie métallique 8.

Ces protubérances ont tendance à engendrer des défauts de fabrication dans les parties du dispositif situées au-dessus du 5^{ème} niveau de métal et à détériorer les performances électriques du condensateur MIM, notamment en termes tension de claquage. Les défauts engendrés sont d'ailleurs d'autant plus importants que la surface prévue pour la partie métallique 8 est importante.

Il se pose le problème d'améliorer la capacité des condensateurs MIM à 3 dimensions intégrés, tout en conservant une densité d'intégration satisfaisante au sein du circuit intégré dans lequel ces condensateurs sont réalisés.

Il se pose en outre le problème de diminuer le nombre de défauts au sein des circuits intégrés dotés de condensateurs MIM.

### EXPOSÉ DE L'INVENTION

L'invention concerne un procédé de réalisation d'un dispositif microélectronique doté d'un ou plusieurs condensateurs à 3 dimensions comprenant les étapes consistant à :
a) réaliser sur un substrat, une pluralité de composants et une pluralité de niveaux métalliques superposés d'interconnexions des composants,
b) former au moins une couche isolante donnée sur une autre couche isolante comportant un ou plusieurs éléments de connexion verticaux de hauteur donnée reposant sur une première bande métallique horizontale d'un niveau métallique d'interconnexion,
c) réaliser, en regard d'au moins une deuxième bande métallique horizontale appartenant audit niveau métallique d'interconnexion et située dans un même plan parallèle au plan principal du substrat que la première bande métallique horizontale, une ou plusieurs tranchées traversant ladite couche isolante donnée,
d) recouvrir les parois et le fond des tranchées d'un empilement formé d'au moins une première fine couche métallique en contact avec lesdites parois, d'au moins une fine couche diélectrique sur ladite première fine couche métallique, et d'au moins une deuxième fine couche métallique sur ladite fine couche diélectrique.

La couche isolante donnée peut avoir une épaisseur supérieure à ladite hauteur donnée desdits éléments métalliques verticaux d'interconnexion.

Selon une possibilité, le procédé peut comprendre en outre, après l'étape d), une étape e) consistant à : combler les tranchées recouvertes par ledit empilement de couches d'au moins un matériau métallique tel que par exemple du Cuivre.

Le procédé peut comprendre en outre après l'étape b), des étapes consistant à :
c') réaliser au moins une tranchée en regard de ladite première bande métallique horizontale et dévoilant lesdits éléments de connexion verticaux,
d') remplir ladite tranchée d'un ou plusieurs matériaux métalliques.

Selon une première possibilité, les étapes c') et d') peuvent être effectuées une fois les étapes c) et d) réalisées.

Selon une variante, les étapes c) et d) peuvent être effectuées une fois les étapes c') et d') réalisées.

Le procédé peut comprendre en outre, la réalisation d'un ou plusieurs plots de contact, par exemple des plots en aluminium, dont au moins un plot en contact avec au moins une tranchée remplie de matériau métallique, par exemple tel que du cuivre.

Selon une mise en oeuvre possible du procédé, à l'étape c) au moins une tranchée peut dévoiler un élément métallique reposant sur ladite deuxième bande métallique, au moins une deuxième tranchée dévoilant un deuxième élément métallique reposant sur ladite deuxième bande métallique.

Selon une autre mise en oeuvre possible du procédé, à l'étape c), au moins deux tranchées dévoilent un même bloc métallique reposant sur ladite deuxième bande métallique.

Selon une autre mise en oeuvre possible du procédé, à l'étape c), au moins une tranchée dévoile la deuxième bande métallique, les tranchées réalisées à l'étape c) traversant également ladite autre couche isolante.

Ladite couche isolante donnée peut avoir une épaisseur supérieure à 0,9 µm.

Ladite autre couche isolante peut avoir une épaisseur inférieure à 3 µm.

L'invention également concerne un dispositif microélectronique doté d'un ou plusieurs condensateurs à 3 dimensions comprenant :
- un substrat et une pluralité de niveaux métalliques d'interconnexions superposés sur le substrat et comportant respectivement une ou plusieurs bandes métallique horizontales,
- au moins une bande métallique horizontale donnée d'un niveau métallique d'interconnexions donné, formée dans l'épaisseur d'une couche isolante donnée, une ou plusieurs tranchées traversant l'épaisseur de ladite couche isolante donnée, les tranchées étant dotées respectivement de parois recouvertes d'un empilement formé : d'au moins une première fine couche métallique en contact avec lesdites parois, d'au moins une fine couche diélectrique et d'au moins une deuxième fine couche métallique en contact avec ladite fine couche diélectrique,
ladite bande métallique donnée étant connectée à au moins une première bande métallique horizontale d'un niveau métallique inférieur audit niveau métallique donné, par l'intermédiaire d'un ou plusieurs éléments de connexion verticaux insérés dans une autre couche isolante,
la première fine couche métallique étant apte à former au moins une partie d'une première armature d'au moins un condensateur, tandis que la deuxième fine couche métallique est apte à former au moins une partie d'une deuxième armature dudit condensateur.

Les éléments de connexion verticaux peuvent avoir une hauteur inférieure à l'épaisseur de ladite couche isolante donnée.

Selon une mise en oeuvre possible du dispositif microélectronique selon l'invention, lesdites tranchées peuvent être remplies en outre par au moins un matériau métallique donné, par exemple tel que du cuivre en contact avec la deuxième fine couche métallique.

Selon une possibilité de mise en oeuvre du dispositif microélectronique, ledit niveau métallique donné peut être le dernier niveau de ladite pluralité de niveaux métalliques superposés, le dispositif comprenant en outre une pluralité de plots métalliques de contact formés sur le niveau métallique donné.

Les plots métalliques de contact peuvent être à base d'un métal résistant au phénomène d'oxydation par exemple tel que l'aluminium réalisé en surface dudit dispositif microélectronique.

Selon une mise en oeuvre du dispositif microélectronique selon l'invention, lesdites tranchées peuvent avoir respectivement un fond recouvert par ledit empilement, ladite première fine couche métallique dudit empilement, étant, au fond desdites tranchées, connectée à au moins une deuxième bande métallique horizontale appartenant audit niveau métallique inférieur, ladite deuxième bande métallique horizontale et ladite première bande métallique horizontale étant situées dans un même plan parallèle au plan principal du substrat.

Selon une première possibilité, au fond d'au moins une tranchée parmi lesdites tranchées, ladite première fine couche métallique dudit empilement, peut être en contact avec au moins un élément métallique traversant ladite autre couche isolante et reposant sur ladite deuxième bande métallique horizontale, au fond d'au moins une autre tranchée parmi lesdites tranchées, ladite première fine couche métallique dudit empilement, étant en contact avec au moins un autre élément métallique traversant ladite autre couche isolante et reposant sur ladite deuxième bande métallique horizontale.

Selon une deuxième possibilité, au fond d'au moins une tranchée parmi lesdites tranchées, ladite première fine couche métallique dudit empilement, est en contact avec au moins un bloc métallique traversant ladite autre couche isolante et reposant sur ladite deuxième bande métallique horizontale, au fond d'au moins une autre tranchée parmi lesdites tranchées, ladite première fine couche métallique dudit empilement, est en contact avec ledit bloc métallique.

Selon une troisième possibilité, lesdites tranchées traversent en outre ladite autre couche isolante, ladite première fine couche métallique dudit empilement, étant, au fond desdites tranchées, en contact avec ladite deuxième bande métallique horizontale.

Ladite couche isolante donnée peut avoir une épaisseur supérieure à 0,9 µm.

Ladite autre couche isolante peut avoir une épaisseur inférieure à 3 µm.

La présente invention concerne également un circuit intégré comprenant un dispositif tel que défini précédemment et doté d'un ou plusieurs modules RF et/ou analogique.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un exemple de dispositif microélectronique doté d'un condensateur MIM en 3 dimensions doté d'armatures verticales integrées entre deux niveaux métalliques d'interconnexion, dans une même couche isolante que les vias métalliques connectant ces deux niveaux,
- les figures 2A-2D, illustrent un exemple de procédé suivant l'invention, de réalisation d'un dispositif doté d'un ou plusieurs condensateurs MIM à 3 dimensions,
- la figure 3, illustre une variante du procédé donné en liaison avec les figures 2A-2D,
- les figures 4A-4B, illustrent une autre variante du procédé donné en liaison avec les figures 2A-2D.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

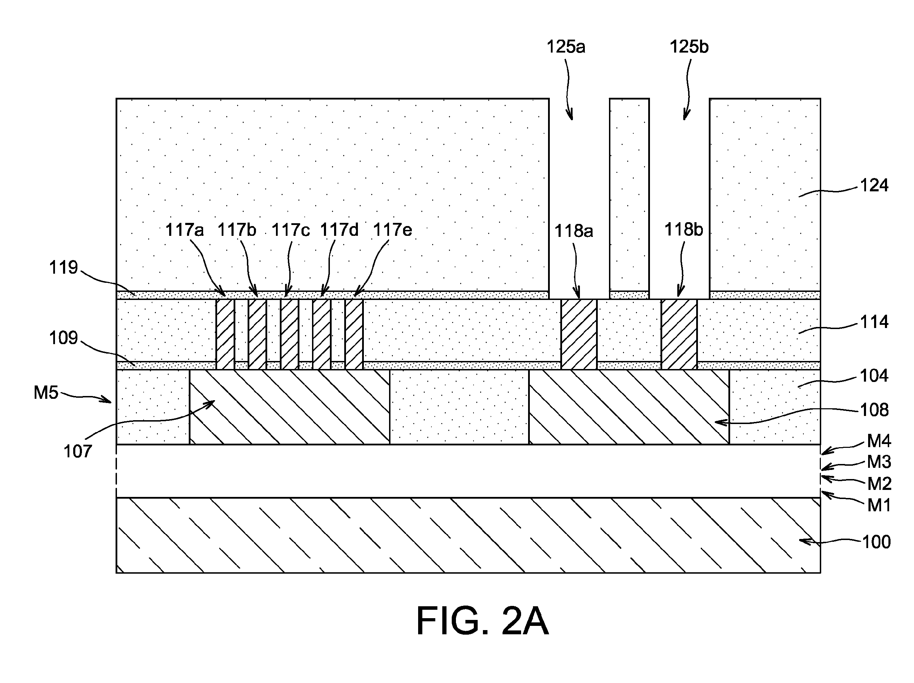

Un exemple de procédé de réalisation d'un dispositif microélectronique suivant l'invention, va à présent être donné en liaison avec les figures 2A-2D.

Le matériau de départ de ce procédé peut être un circuit intégré en cours de réalisation, par exemple un circuit comprenant au moins un module dédié à des applications radiofréquences et/ou analogiques. Ce circuit comprend un substrat 100, sur lequel une pluralité de composants ont été formés et peut être déjà doté d'une pluralité de niveaux métalliques d'interconnexions superposés, par exemple de cinq niveaux métalliques d'interconnexions M1, M2, M3, M4, M5 (les composants et les quatre premiers niveaux métalliques d'interconnexion M1, ..., M4, étant schématisés par un bloc en traits discontinus sur les figures 2A-2D) comportant chacun au moins une ou plusieurs lignes métalliques ou bandes métalliques horizontales. Tout au long de la présente description, on entendra par lignes ou bandes « horizontales » des lignes ou des bandes s'étendant dans un plan parallèle au plan principal du substrat 100, le plan principal du substrat 100 étant quant à lui défini comme un plan passant par le substrat et parallèle au plan [*O;i̅;j̅*] d'un repère orthogonal [O;*i̅*;*j*;*k*] représenté sur les figures 2A-2D. Le cinquième niveau métallique M5 d'interconnexions comporte une pluralité de lignes ou de bandes horizontales à base d'un matériau métallique, par exemple tel que du cuivre.

Sur la figure 2A, une partie de ce cinquième niveau métallique M5, comportant une première bande métallique 107 horizontale et une deuxième bande métallique horizontale 108, est représentée. La première bande métallique 107 et la deuxième bande métallique horizontale 108 sont situées dans une couche à base de matériau diélectrique 104, par exemple à base de SiO₂ ou de SiOC et d'épaisseur par exemple comprise entre 0,1 µm et 3 µm, par exemple de l'ordre de 0,2 µm. Sur les bandes conductrices 107, 108 sont formés respectivement des éléments métalliques d'interconnexion verticaux 117a, 117b, 117c, 117d, 117e, 118a, 118b, communément appelés « vias ». Tout au long de la présente description, on entendra par éléments « verticaux » des éléments s'étendant dans une direction orthogonale ou sensiblement orthogonale au plan principal du substrat 100.

Les éléments métalliques verticaux 117a, 117b, 117c, 117d, 117e, 118a, 118b, peuvent avoir été formés dans toute l'épaisseur d'une couche isolante 109-114, par exemple par un procédé au cours duquel, dans la couche isolante 109-114, des trous sont réalisés en regard de la première bande conductrice métallique 107 et en regard de la deuxième bande conductrice métallique 108, puis un remplissage des trous, par au moins un matériau métallique tel que du cuivre est effectuée. Un polissage mécano-chimique peut être réalisé, de manière à supprimer le matériau métallique en excédant dépassant de l'embouchure des trous et reposant sur la couche isolante 109-114.

La couche isolante 109-114 dans laquelle sont insérés les éléments métalliques d'interconnexion verticaux 117a, 117b, 117c, 117d, 117e, 118a, 118b, peut être formée d'une fine sous-couche 109, barrière de diffusion, à base d'un matériau diélectrique, par exemple tel que du Si₃N₄, ou du SiCN, recouverte par une deuxième sous-couche de matériau diélectrique 114, par exemple à base de SiO₂ ou de SiOC. La couche isolante 109-114 a une épaisseur comprise par exemple entre 0,1 et 3 µm. Les éléments métalliques verticaux 117a, 117b, 117c, 117d, 117e, 118a, 118b, formés dans la couche isolante 109-114 peuvent avoir une hauteur h (mesurée dans une direction parallèle à celle du vecteur *k̅* du repère [O;*i̅*;*j̅*;*k̅*]) sensiblement égale à l'épaisseur de la couche isolante 109-114. Les éléments métalliques verticaux 117a, 117b, 117c, 117d, 117e, 118a, 118b, peuvent avoir une dimension critique par exemple de l'ordre de 0,3 µm ou de 0,4 µm. Par dimension critique, on entend la plus petite dimension d'un élément mesurée dans une direction parallèle au plan principal du substrat 100.

Après réalisation des éléments métalliques verticaux 117a, 117b, 117c, 117d, 117e, 118a, 118b, une autre couche isolante 119-124 est formée. L'autre couche isolante 119-124 peut être réalisée par dépôt d'une fine sous-couche 119, barrière de diffusion, à base d'un matériau diélectrique, par exemple tel que du Si₃N₄ ou du SiCN sur laquelle on dépose une deuxième sous-couche de matériau diélectrique 114, par exemple à base de SiO₂ ou de SiOC. La couche isolante 119-124 peut être prévue avec une épaisseur importante, pour accueillir un sixième niveau métallique M6 comportant des lignes ou bandes métalliques horizontales d'épaisseur importante. Le sixième niveau métallique M6 peut être prévu avec une épaisseur de métal importante, supérieure à la hauteur des vias 117a, 117b, 117c, 117d, 117e, 118a, 118b, adaptée pour des applications RF ou/et analogique. Le sixième niveau métallique M6 peut être un niveau dans lequel une épaisseur importante de métal est requise, afin de réaliser des composants tel que par exemple des inductances ayant un facteur de qualité Q élevé, ou des pistes métalliques susceptibles d'acheminer une densité de courant importante, sont destinés à être réalisés. Par épaisseur importante, on entend une épaisseur par exemple au moins supérieure à 0,9 micromètres.

L'autre couche isolante 119-124 est prévue avec une épaisseur supérieure à l'épaisseur de la couche isolante 109-114 dans laquelle les vias 117a, 117b, 117c, 117d, 117e, 118a, 118b, ont été réalisés. Par épaisseur « importante » on entend par exemple que l'épaisseur de l'autre couche isolante 119-124 est supérieure à 0,9 µm. L'autre couche isolante 119-124 peut avoir une épaisseur comprise par exemple entre 0,9 µm et 10 µm, par exemple de l'ordre de 3 µm ou de 4 µm.

On réalise ensuite, en regard de la deuxième bande métallique horizontale 108, appartenant au niveau métallique M5 et située dans un même plan parallèle au plan principal du substrat 100 que la première bande métallique 107, des tranchées 125a, 125b, traversant ladite autre couche isolante 119-124, et dévoilant chacune un élément conducteur 118a, 118b. Les tranchées 125a, 125b, peuvent être réalisées à l'aide d'au moins une étape de photolithographie et de gravure (figure 2A).

On dépose ensuite un empilement MIM (« MIM » pour Métal-Isolant-Métal) de manière à recouvrir les parois et le fond des tranchées 125a, 125b. L'empilement MIM est réalisé par dépôt d'une première fine couche métallique 130, par exemple à base de TiN ou de TaN recouvrant lesdites parois et le fond des tranchées 125a, 125b, d'épaisseur par exemple de l'ordre de un ou plusieurs dizaines nanomètres. Puis, une fine couche de matériau diélectrique 132 d'épaisseur par exemple de l'ordre de un ou plusieurs nanomètres est déposée sur la première fine couche métallique 130. La fine couche de matériau diélectrique 132 peut être par exemple à base de Al₂O₃ ou de HfO₂ ou de Si₃N₄, ou de Ta₂O₅ ou d'une combinaison des matériaux précités.

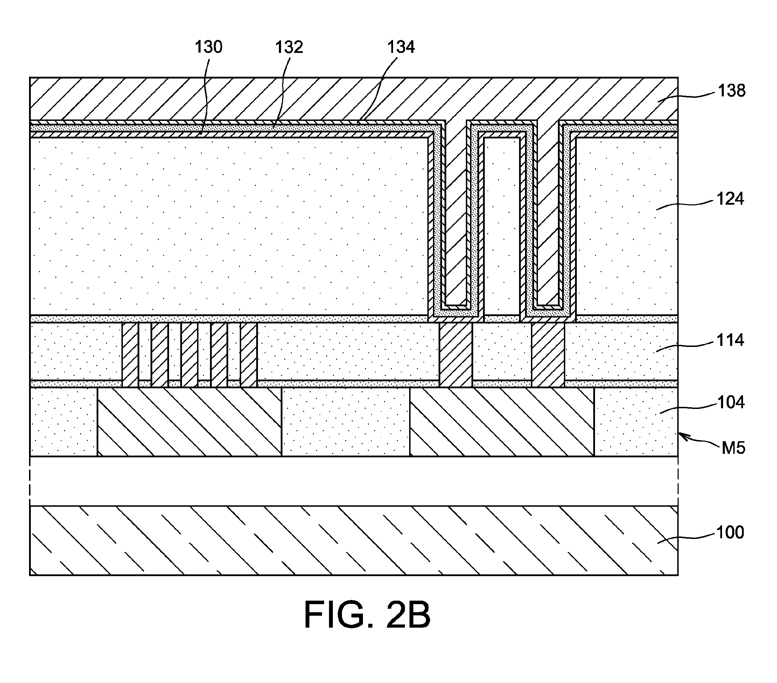

Ensuite, une deuxième fine couche métallique 134 par exemple à base de TiN ou de TaN d'épaisseur par exemple de l'ordre d'une ou plusieurs dizaines de nanomètres est déposée sur ladite fine couche de matériau diélectrique 132. Puis, on comble les tranchées recouvertes par ledit empilement MIM de couches 130, 132, 134, à l'aide d'au moins un matériau métallique 138, par exemple tel que du cuivre (figure 2B).

Ensuite, on retire les couches 130, 132, 134, ainsi que le matériau métallique 138 dans une zone située au dessus de la face supérieure de la couche de matériau diélectrique 124. Ce retrait peut être réalisé à l'aide d'un polissage mécano-chimique (CMP) jusqu'à atteindre la face supérieure de la couche de matériau diélectrique 124.

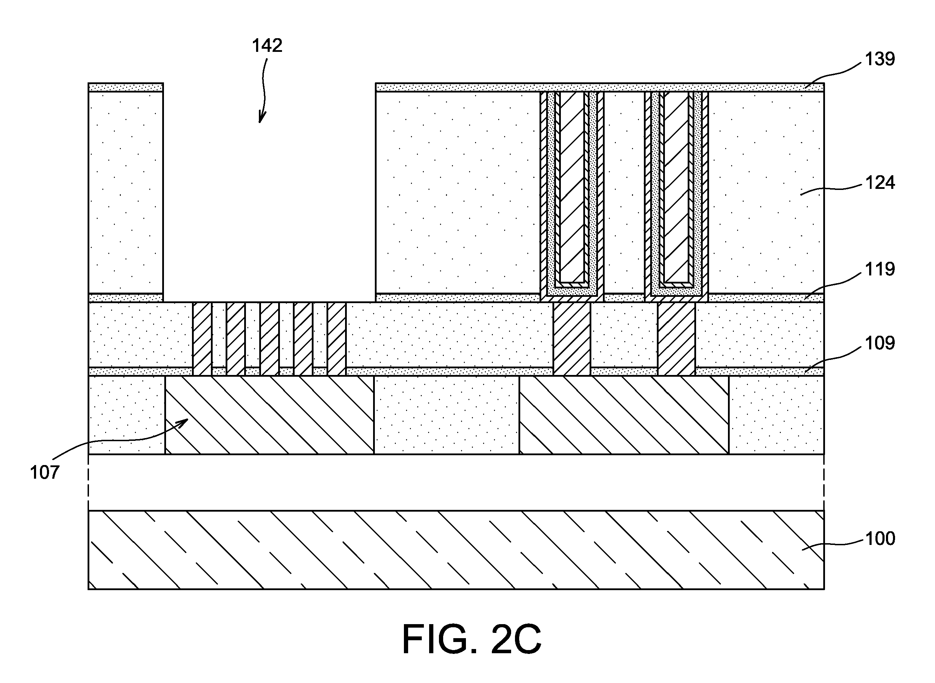

Une fine couche de matériau diélectrique 139, d'épaisseur par exemple de l'ordre de 500 angströms et par exemple à base de Si₃N₄ peut être ensuite déposée sur la couche de matériau diélectrique 124. Puis, on forme une ou plusieurs tranchées à travers les couches diélectriques 139, 124, 119, par exemple à l'aide d'au moins une étape de photolithographie et de gravure. Parmi les tranchées réalisées figure au moins une tranchée 142 en regard de la première bande métallique 107 du niveau métallique M5, ladite tranchée 142 dévoilant les éléments métalliques verticaux 117a, 117b, 117c, 117d, 117e. Dans la tranchée 142, on dépose ensuite une fine couche métallique 145 barrière de diffusion, par exemple à base de TaN et d'épaisseur par exemple de l'ordre de 100 angströms, de manière à recouvrir les parois et le fond de la tranchée 142 (figure 2C).

Ensuite, on comble la tranchée 142 à l'aide d'au moins un matériau métallique 146, par exemple tel que du cuivre. La tranchée 142 remplie de matériau métallique forme une bande métallique 147 horizontale épaisse du sixième niveau métallique M6. Une étape de polissage mécano-chimique peut être ensuite prévue. L'épaisseur de la bande métallique 147 horizontale peut être sensiblement égale à l'épaisseur cumulée des couches de matériau diélectrique 119, 124, 139, par exemple supérieure à 0,9 µm. Dans cet exemple, le sixième niveau métallique M6 est le dernier niveau de lignes métalliques d'interconnexion prévues pour le circuit intégré. Les tranchées dont les parois ont été couvertes par l'empilement MIM sont situées dans un même plan parallèle au plan principal du substrat 100 que les bandes métalliques 147 horizontales du dernier niveau M6 d'interconnexion.

Dans le cas où le polissage précédemment évoqué a supprimé la couche de matériau diélectrique 139, cette dernière peut être ensuite remplacée.

On effectue ensuite le dépôt d'une autre couche de matériau diélectrique 154, par exemple à base d'oxyde SiOC ou de SiO₂ et d'épaisseur comprise par exemple entre 0,5 et 1 µm.

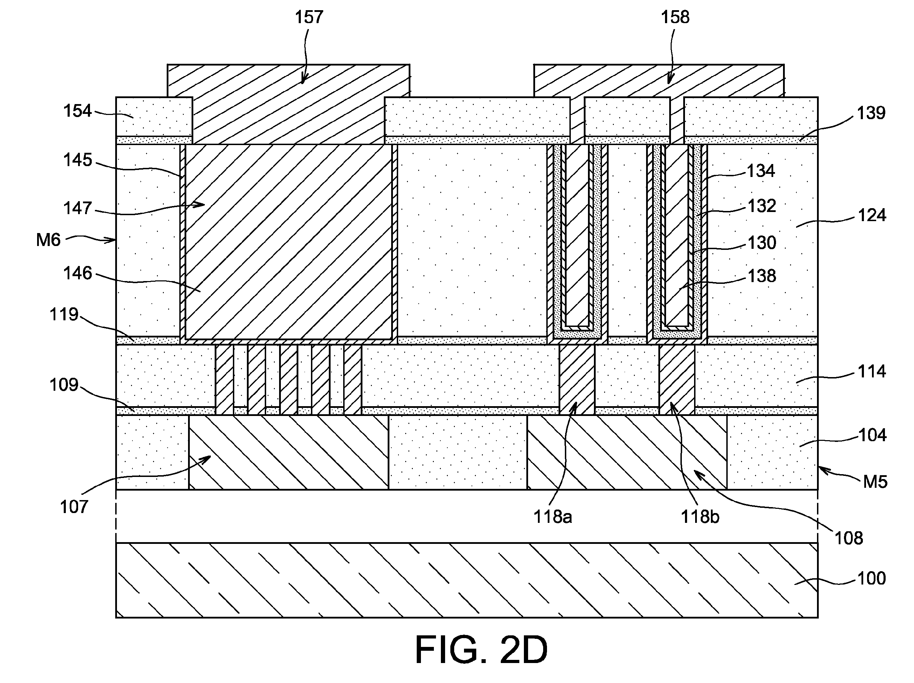

Ensuite, on réalise une pluralité de trous dans la couche de matériau diélectrique 154, dont au moins un trou dévoilant la bande métallique épaisse 147, et un ou plusieurs trous dévoilant respectivement une tranchée remplie de l'empilement MIM et du matériau métallique 138. Ensuite, on effectue un dépôt d'un matériau métallique donné, qui peut être différent du matériau métallique 138 en contact de l'empilement MIM et du matériau métallique à base duquel la bande métallique 147 est formée. Le matériau métallique donné est de préférence un matériau résistant aux phénomènes d'oxydation, par exemple tel que l'aluminium. Dans la couche de matériau métallique donné, par exemple à base d'aluminium, on réalise ensuite, par exemple par photolithographie puis gravure, une pluralité de plots de connexion 157, 158, comprenant par exemple au moins un plot en contact avec la bande métallique épaisse 157 et au moins un plot 158 en contact avec une ou plusieurs tranchées comblées par l'empilement MIM et le matériau métallique 138 (figure 2D).

Le dispositif microélectronique réalisé à l'aide du procédé précédemment décrit, est ainsi doté d'un ou plusieurs condensateurs avec des armatures métalliques comportant respectivement au moins une partie réalisant un angle non-nul avec le plan principal du substrat et par exemple orthogonale au plan principal du substrat 100. Ces parties d'armatures métalliques sont réalisées dans une même couche isolante que les bandes métalliques horizontales épaisses du dernier niveau métallique M6, ce qui permet, à encombrement équivalent dans une direction parallèle au plan principal du substrat, d'obtenir une surface d'armatures plus importantes que lorsque les parties verticales des armatures sont comme pour le dispositif décrit précédemment en liaison avec la figure 1, réalisées dans une même couche que les vias. Le ou les condensateurs d'un dispositif microélectronique réalisé à l'aide d'un procédé suivant l'invention, peuvent ainsi avoir à encombrement équivalent dans une direction parallèle au plan principal du substrat, une capacité plus importante que les condensateurs du dispositif décrit précédemment en liaison avec la figure 1. Une intégration de l'empilement MIM au sein d'un niveau métallique formé de bandes métalliques horizontales permet également de conserver une épaisseur faible entre ce niveau donné et le niveau métallique inférieur. Autrement dit, un tel mode d'intégration s'adapte à des technologies pour les lesquels on souhaite de plus en plus diminuer la hauteur des vias et l'épaisseur des couches isolantes dans lesquelles les vias sont réalisées et qui séparent deux niveaux métalliques.

Une intégration de l'empilement MIM au sein d'un niveau métallique, au dessus des vias d'interconnexion, permet également de diminuer la défectivité au sein du dispositif. Des éventuelles excroissances métalliques sur le 5^{ème} niveau de métal n'affectent pas le condensateur MIM dans la mesure où contrairement au dispositif de la figure 1 précédemment décrit, cet empilement MIM n'est pas formé directement sur le 5^{ème} niveau de métal.

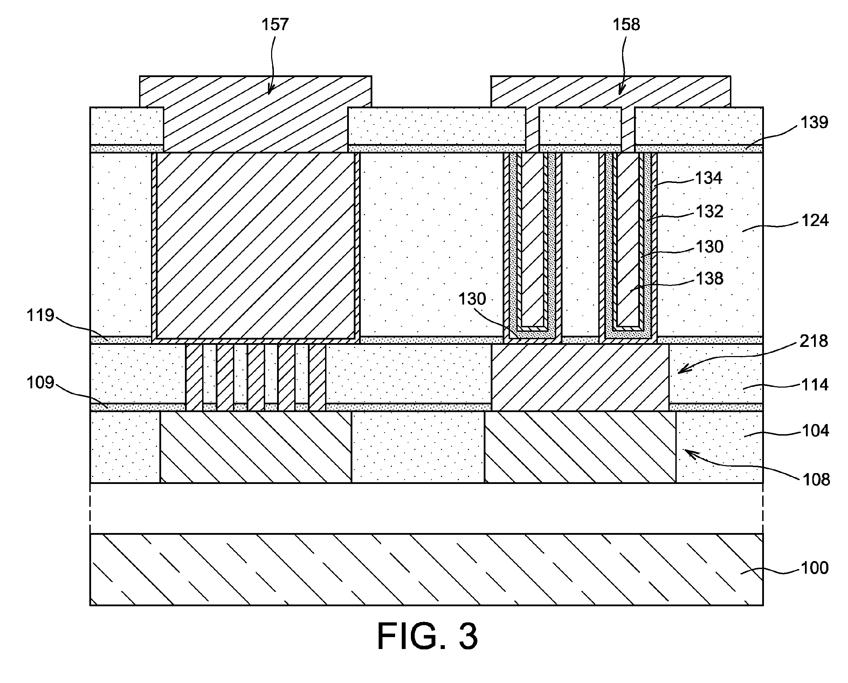

Une variante de réalisation est donnée en liaison avec la figure 3.

Pour cette variante, les éléments métalliques 118a, 118b formés sur la deuxième bande métallique 108, sont remplacés par un bloc métallique 218 de dimension critique plus importante que celle de ces derniers. Le bloc métallique 218 peut ainsi avoir une dimension critique supérieure à celle des éléments métalliques 117a, 117b, 117c, 117d, 117e, formés sur la première bande métallique horizontale 107. Le bloc métallique 218 est réalisé en même temps que les éléments métalliques 117a, 117b, 117c, 117d, 117e, par remplissage de la couche isolante 109-114 à l'aide d'un matériau métallique tel que du cuivre. Ensuite, plusieurs tranchées 125a, 125b, sont formées de manière à dévoiler le bloc métallique 218. Les tranchées 125a, 125b, sont ensuite remplies de la manière décrite précédemment en liaison avec la figure 2B. Puis, on réalise les mêmes étapes que décrites précédemment en liaison avec les figures 2C et 2D. A l'issue du procédé, plusieurs tranchées remplies de l'empilement MIM reposent sur le même bloc métallique 218 reposant lui-même sur une bande métallique 108 du 5^{ème} niveau de métal.

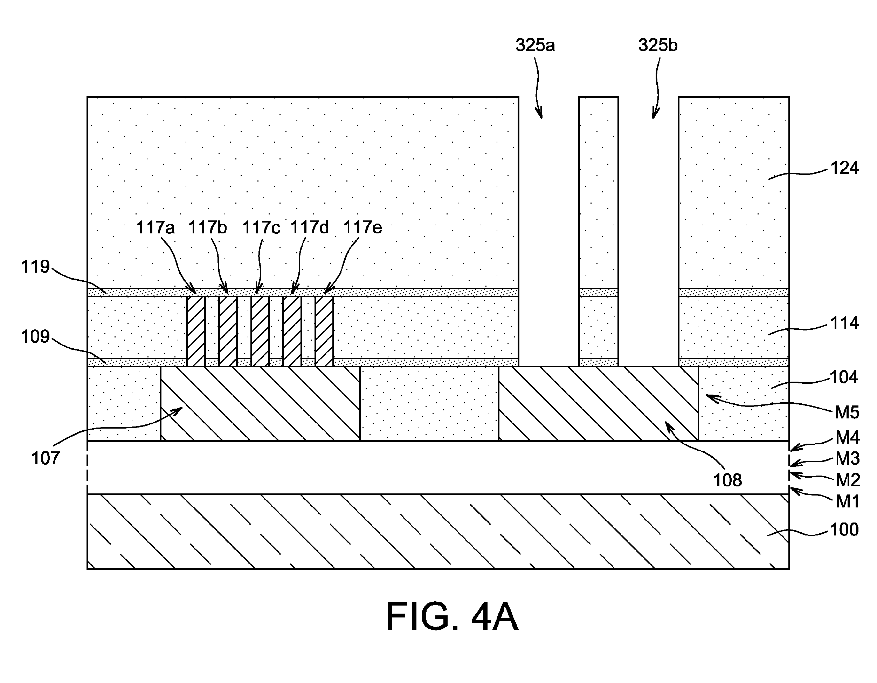

Une autre variante de réalisation est donnée en liaison avec les figures 4A-4B.

Pour cette variante, on ne réalise pas les éléments métalliques 118a, 118b sur la deuxième bande métallique 108. Lors de l'étape de formation des vias 117a, 117b, 117c, 117d, 117e, la couche isolante est laissée intacte et n'est pas gravée dans une zone située en regard de la deuxième bande métallique 108.

Puis, pour l'étape de formation de tranchées dans la couche isolante 119-124 en regard de la bande métallique 108, on réalise des tranchées (référencées cette fois 325a, 325b sur la figure 4A), également dans la couche isolante 104-109, de sorte qu'au fond des tranchées 325a, 325b, la deuxième bande métallique 108 est dévoilée.

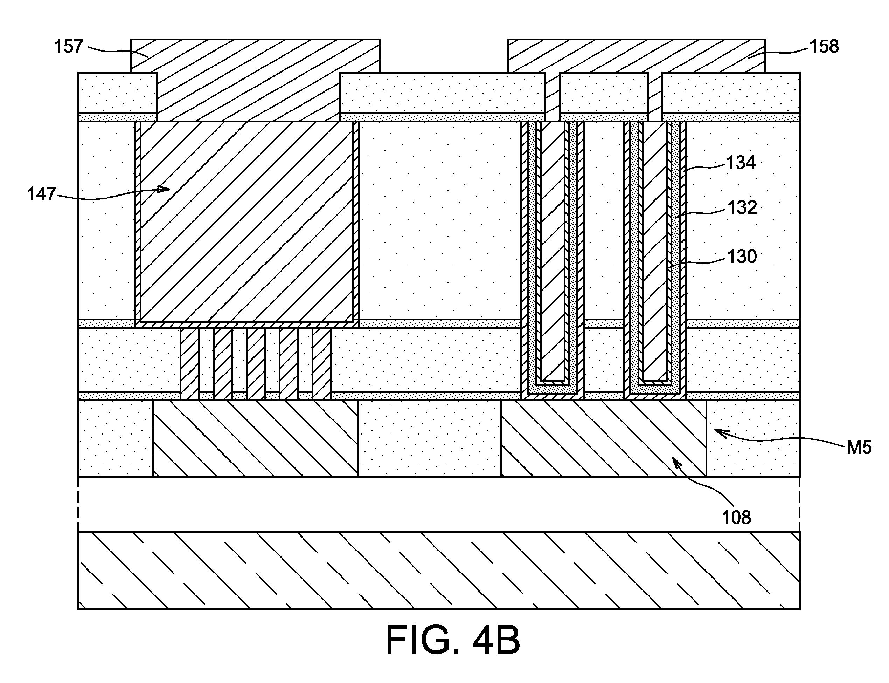

On réalise ensuite les mêmes étapes que décrites précédemment en liaison avec les figures 2C et 2D. A l'issue du procédé, plusieurs tranchées remplies de l'empilement MIM reposent sur la bande métallique 108 du 5^{ème} niveau de métal (figure 4B).

Selon une variante de l'un ou l'autre des procédés précédemment décrits, la réalisation de bandes métalliques 147 horizontales épaisses du niveau métallique M6, par formation de tranchées dans une couche isolante puis remplissage des tranchées d'un matériau métallique, peut être effectuée avant la formation de l'empilement MIM, cet empilement étant ensuite formé par réalisation de tranchées dans ladite couche isolante, puis recouvrement des parois et le fond des tranchées de l'empilement MIM.

## Revendications

1. Dispositif microélectronique doté d'un ou plusieurs condensateurs à 3 dimensions comprenant :
- un substrat (100) et une pluralité de niveaux (M1,..., M5, M6) métalliques d'interconnexions superposés sur le substrat et comportant respectivement une ou plusieurs bandes métalliques horizontales,
- au moins une bande métallique (147) horizontale donnée d'un niveau métallique (M6) d'interconnexions donné, formée dans l'épaisseur d'une couche isolante (119-124) donnée, une ou plusieurs tranchées traversant l'épaisseur de ladite couche isolante donnée, les tranchées étant dotées respectivement de parois recouvertes d'un empilement formé : d'au moins une première fine couche métallique (130) en contact avec lesdites parois et apte à former au moins une partie d'une première armature d'au moins un condensateur, d'au moins une fine couche diélectrique (132) et d'au moins une deuxième fine couche métallique (134) en contact avec ladite fine couche diélectrique (132) et apte à former au moins une partie d'une deuxième armature dudit condensateur, ladite bande métallique (147) donnée étant connectée à au moins une première bande métallique horizontale (107) d'un niveau métallique (M5) inférieur audit niveau métallique donné (M6), par l'intermédiaire d'un ou plusieurs éléments de connexion verticaux (117a, 117b, 117c, 117d, 117e) insérés dans une autre couche isolante (109-114).

2. Dispositif microélectronique selon la revendication 1, les éléments de connexion verticaux ayant une hauteur inférieure à l'épaisseur de ladite couche isolante (119-124) donnée.

3. Dispositif microélectronique selon la revendication 1 ou 2, lesdites tranchées étant remplies en outre par au moins un matériau métallique (138) donné en contact avec la deuxième fine couche métallique (134).

4. Dispositif microélectronique selon la revendication 3, dans lequel ledit niveau métallique donné (M6) est le dernier niveau de ladite pluralité de niveaux (M1,..., M6) métalliques superposés, le dispositif comprenant en outre une pluralité de plots métalliques (157, 158) de contact formés sur le niveau métallique (M6) donné.

5. Dispositif microélectronique selon l'une des revendications 1 à 4, dans lequel lesdites tranchées ont respectivement un fond recouvert par ledit empilement, ladite première fine couche métallique (130) dudit empilement, étant, au fond desdites tranchées, connectée à au moins une deuxième bande métallique horizontale (108) appartenant audit niveau métallique inférieur (M5), ladite deuxième bande métallique horizontale (108) et ladite première bande métallique horizontale (107) étant situées dans un même plan parallèle au plan principal du substrat.

6. Dispositif microélectronique selon la revendication 5, dans lequel :
au fond d'au moins une tranchée parmi lesdites tranchées, ladite première fine couche métallique (130) dudit empilement, est en contact avec au moins un élément métallique (118a) traversant ladite autre couche isolante (109-114) et reposant sur ladite deuxième bande métallique horizontale (108), au fond d'au moins une autre tranchée parmi lesdites tranchées, ladite première fine couche métallique (130) dudit empilement, étant en contact avec au moins un autre élément métallique (118b) traversant ladite autre couche isolante (109-114) et reposant sur ladite deuxième bande métallique horizontale (108).

7. Dispositif microélectronique selon la revendication 5, dans lequel, au fond d'au moins une tranchée parmi lesdites tranchées, ladite première fine couche métallique (130) dudit empilement, est en contact avec au moins un bloc métallique (218) traversant ladite autre couche isolante (109-114) et reposant sur ladite deuxième bande métallique horizontale (108), au fond d'au moins une autre tranchée parmi lesdites tranchées, ladite première fine couche métallique (130) dudit empilement, est en contact avec ledit bloc métallique (218).

8. Dispositif microélectronique selon la revendication 5, dans lequel, lesdites tranchées traversent en outre ladite autre couche isolante (109-114), ladite première fine couche métallique (130) dudit empilement, étant, au fond desdites tranchées, en contact avec ladite deuxième bande métallique horizontale (108).

9. Circuit intégré comprenant un dispositif selon l'une des revendications 1 à 8, et doté d'un ou plusieurs modules RF et/ou analogique.

10. Procédé de réalisation d'un dispositif microélectronique doté d'un ou plusieurs condensateurs à 3 dimensions comprenant les étapes consistant à :
a) réaliser sur un substrat (100), une pluralité de composants et une pluralité de niveaux métalliques (M1,..., M5, M6) superposés d'interconnexions des composants,
b) former au moins une couche isolante (119-124) donnée sur une autre couche isolante (109-114) et dans laquelle figurent un ou plusieurs éléments de connexion verticaux (117a, 117b, 117c, 117d, 117e) de hauteur donnée reposant sur une première bande métallique horizontale (107) d'un niveau métallique d'interconnexion (M5),
c) réaliser, en regard d'au moins une deuxième bande métallique horizontale (108) appartenant audit niveau métallique d'interconnexion (M5) et située dans un même plan parallèle au plan principal du substrat (100) que la première bande métallique horizontale (107), une ou plusieurs tranchées (125a,125b) traversant ladite couche isolante (119-124) donnée,
d) recouvrir les parois et le fond des tranchées (125a, 125b, 325a, 325b) d'un empilement formé d'au moins une première fine couche métallique (130) en contact avec les dites parois, d'au moins une fine couche diélectrique (132) sur ladite première fine couche métallique (130), et d'au moins une deuxième fine couche métallique (134) sur ladite fine couche diélectrique (132).

11. Procédé selon la revendication 10, ladite couche isolante donnée ayant une épaisseur supérieure à ladite hauteur donnée desdits éléments métalliques verticaux d'interconnexion.

12. Procédé selon la revendication 10 ou 11, comprenant en outre, après l'étape d), une étape e) consistant à : combler les tranchées (125a, 125b) recouvertes par ledit empilement des couches (130, 132, 134) d'au moins un matériau métallique (138).

13. Procédé selon l'une des revendications 10 à 12, comprenant en outre après l'étape b), des étapes consistant à :
c') réaliser au moins une tranchée (142) en regard de ladite première bande métallique horizontale (107) et dévoilant lesdits éléments de connexion verticaux (117a, 117b, 117c, 117d, 117e),
d') remplir ladite tranchée (142) d'un ou plusieurs matériaux métalliques (145, 146).

14. Procédé selon la revendication 13, comprenant, une fois les étapes e) et d') effectuées, la réalisation d'un ou plusieurs plots de contact, dont au moins un plot de contact avec au moins une tranchée remplie de matériau métallique.

15. Procédé selon l'une des revendications 10 à 14, dans lequel à l'étape c) au moins une tranchée dévoile un élément métallique (118a) reposant sur ladite deuxième bande métallique (108), au moins une deuxième tranchée dévoilant un deuxième élément métallique (118b) reposant sur ladite deuxième bande métallique (108).

16. Procédé selon l'une des revendications 10 à 14, dans lequel à l'étape c), au moins deux tranchées dévoilent un même bloc métallique (218) reposant sur ladite deuxième bande métallique (108).

17. Procédé selon l'une des revendications 10 à 14, dans lequel à l'étape c), au moins une tranchée (325a, 325b) dévoile la deuxième bande métallique (108), les tranchées réalisées à l'étape c) traversant également ladite autre couche isolante (109-114).
